# EUROPEAN PATENT APPLICATION

(11) **EP 4 671 914 A1**
(43) Date of publication of application: **31.12.2025**
(21) Application number: 25178646.3
(22) Date of filing: 23.05.2025
(51) Int. Cl.: G06F 1/16, H10K 77/10, H05K 3/00, H05K 1/18, H05K 1/14, H01L 21/67, H05K 1/02

(54) **BENDING DEVICE, ELECTRONIC DEVICE MANUFACTURED THROUGH THE SAME, AND METHOD OF MANUFACTURING ELECTRONIC DEVICE USING THE SAME**

(30) Priority: 27.06.2024 KR 20240084363; 26.08.2024 KR 20240114312
(71) Applicant: Samsung Display Co., Ltd., Yongin-si, Gyeonggi-do 17113 (KR)
(72) Inventor: KIM, DONGWOO, 17113 Yongin-si (KR); JUNG, JANGHO, 17113 Yongin-si (KR); HAN, HEE SOO, 17113 Yongin-si (KR)
(74) Representative: Taor, Simon Edward William

(57) **Abstract**

A bending device includes a stage configured to accommodate a display panel; and a bending part adjacent to the stage and configured to accommodate a main circuit board, the bending part including a main plate reciprocating in the first direction; a first block on the main plate; a plurality of rotation supports arranged on sides of the first block, a second block between the rotation supports, coupled to the first block, and configured to reciprocate in a third direction; a third block closer to the stage than the second block is, between the rotation supports, and configured to rotate about a rotation axis parallel to a second direction; and a fourth block coupled to one side of the third block, and including a main body configured to reciprocate in the first direction and a sub-body coupled to the main body and configured to reciprocate in the third direction.

## Description

### CROSS-REFERENCE TO RELATED APPLICATIONS

The present application claims priority to and the benefit of Korean Patent Application No. 10-2024-0084363, filed on June 27, 2024, and Korean Patent Application No. 10-2024-0114312, filed on August 26, 2024, in the Korean Intellectual Property Office.

### BACKGROUND

### 1. FIELD

Aspects of embodiments of the present disclosure relate to a bending device, an electronic device manufactured through the same, and a method of manufacturing an electronic device using the same.

### 2. DESCRIPTION OF THE RELATED ART

Various electronic devices used in multimedia devices, such as televisions, mobile phones, tablet computers, navigation systems, and game consoles have been developed. The electronic device includes a display panel that displays an image and circuit boards that are coupled to the display panel and provide driving signals to the display panel.

The above information disclosed in this Background section is for enhancement of understanding of the background of the present disclosure, and therefore, it may contain information that does not constitute a related (or prior) art.

### SUMMARY

Aspects of embodiments of the present disclosure are directed to a bending device that reduces a space occupied by a connection circuit board, an electronic device manufactured through the same, and a method of manufacturing an electronic device using the same.

According to an embodiment of the present disclosure, a bending device includes: a stage configured to accommodate a display panel; and a bending part adjacent to the stage in a first direction and configured to accommodate a main circuit board, the bending part including: a main plate configured to reciprocate in the first direction; a first block on the main plate; a plurality of rotation supports arranged on sides of the first block, the sides of the first block being opposite to each other in a second direction intersecting the first direction; a second block between the rotation supports, coupled to the first block, and configured to reciprocate in a third direction intersecting a plane defined by the first direction and the second direction; a third block closer to the stage than the second block is, between the rotation supports, and configured to rotate about a rotation axis parallel to the second direction; and a fourth block coupled to one side of the third block facing the stage from among sides of the third block, the sides of the fourth block being opposite to each other in the first direction, and including a main body configured to reciprocate in the first direction and a sub-body coupled to the main body and configured to reciprocate in the third direction with respect to the main body.

The bending part may include a first rail under the main plate and extending in the first direction, and the main plate may be configured to reciprocate along the first rail in the first direction.

The first block may include: a block body; and a second rail in grooves defined in one side of the block body facing the stage from among the sides of the block body, which are opposite to each other in the first direction, and extend in the third direction, and the second block may be configured to reciprocate along the second rail in the third direction.

In response to the second block reciprocating in the third direction, the rotation supports, the third block, and the main body may be configured to reciprocate in the third direction.

The bending part further may include: a first driving unit on a lower surface of the third block; and a shaft extending in the second direction, connected to the first driving unit, and configured to rotate about a rotation axis parallel to the second direction. The main body may include: a first portion on the one side of the third block; a second portion extending from the first portion in the first direction and on the lower surface of the third block; and a third rail on a lower surface of the second portion, extending in the first direction, and engaged with the shaft, and in response to the shaft rotating, the main body may be configured to reciprocate in the first direction.

In response to the main body moving in the first direction, the sub-body may be configured to move in the first direction.

The bending part further may include: a second driving unit inside the main body and rotating about a rotation axis parallel to the third direction; a screw adjacent to the second driving unit and rotating about the rotation axis parallel to the third direction; a timing belt configured to connect the second driving unit and the screw; and a connection member coupled to the screw and configured to reciprocate along the screw in the third direction. The sub-body may be coupled to the connection member, and in response to the screw rotating, the sub-body may be configured to reciprocate in the third direction.

A distance between the sub-body and the stage may be constant.

The third block and the sub-body may move in opposite directions.

According to an embodiment of the present disclosure a method of manufacturing an electronic device includes: arranging a display panel on a stage and arranging a connection circuit board electrically connected to the display panel and a main circuit board electrically connected to the connection circuit board on a bending part adjacent to the stage in a first direction; molding the connection circuit board as the bending part moves; and bending the connection circuit board as the bending part rotates about a rotation axis parallel to a second direction intersecting the first direction, wherein the bending part includes: a main plate configured to reciprocate in the first direction; a first block on the main plate; a plurality of rotation supports arranged on sides of the first block, the sides being opposite to each other in the second direction intersecting the first direction; a second block between the rotation supports, coupled to the first block, and configured to reciprocate in a third direction intersecting a plane defined by the first direction and the second direction; a third block that is closer to the stage than the second block between the rotation supports and rotates about a rotation axis parallel to the second direction; and a fourth block on one side facing the stage from among sides of the third block, the sides being opposite to each other in the first direction.

The bending part further may include a first rail under the main plate and extending in the first direction, and the main plate may be configured to reciprocate along the first rail in the first direction.

The first block may include: a block body; and a second rail in grooves defined on one side of the block body facing the stage from among sides of the block body, the grooves extending in a third direction intersecting a plane defined by the first direction and the second direction, the sides of the block body being opposite to each other in the first direction, and the second block may be configured to reciprocate along the second rail in the third direction, and in response to the second block reciprocating in the third direction, the rotation supports, the third block, and the fourth block may be configured to reciprocate in the third direction.

The bending part further may include: a first driving unit on a lower surface of the third block; and a shaft extending in the second direction, connected to the first driving unit, and configured to rotate about a rotation axis parallel to the second direction, and the fourth block may include: a main body coupled to one side of the third block facing the stage from among sides of the third block opposite to each other in the first direction and configured to reciprocate in the first direction; and a sub-body connected to the main body and configured to reciprocate in the third direction with respect to the main body.

The main body may include: a first portion on the one side of the third block; a second portion extending from the first portion in the first direction and on the lower surface of the third block; and a third rail on a lower surface of the second portion, extending in the first direction, and engaged with the shaft, and in response to the shaft rotating, the main body may be configured to move in a direction opposite to the first direction.

The bending part further may include: a second driving unit inside the main body and configured to rotate about a rotation axis parallel to the third direction; a screw adjacent to the second driving unit and configured to rotate about the rotation axis parallel to the third direction; a timing belt configured to connect the second driving unit and the screw; and a connection member coupled to the screw. The sub-body may be coupled to the connection member, and in response to the screw rotating, the sub-body may be configured to reciprocate in the third direction.

Heights of sides of the connection circuit board opposite to each other in the first direction may be different from each other.

The molded connection circuit board may have an inclination.

According to an embodiments of the present disclosure an electronic device includes: a display panel; a main circuit board on a rear surface of the display panel; a connection circuit board electrically connected to the display panel on one side thereof and electrically connected to the main circuit board on another side thereof, the connection circuit board having: a first area on the display panel; a second area extending from the first area and being bent; a third area under the display panel and extending from the second area; a fourth area extending from the third area and having an inclination; and a fifth area extending from the fourth area and attached to an upper surface of the main circuit board opposite to a lower surface of the main circuit board facing the display panel; and a driving chip mounted on the connection circuit board.

The third area of the connection circuit board may be attached to the rear surface of the display panel.

A height of an upper surface of the fourth area of the connection circuit board facing the rear surface of the display panel may decrease toward the main circuit board.

According to an aspect, there is provided a bending device as set out in claim 1. Additional features are set out in claims 2 to 7.

According to an aspect, there is provided a method as set out in claim 8. Additional features are set out in claims 9 to 13.

According to an aspect, there is provided an electronic device as set out in claim 14. Additional features are set out in claim 15.

### BRIEF DESCRIPTION OF THE DRAWINGS

The above and other objects and features of the present disclosure will become apparent by describing in detail embodiments thereof with reference to the accompanying drawings.
FIG. 1 is a perspective view of a bending device according to an embodiment of the present disclosure.
FIG. 2 is a side view of a portion of a main plate and first rails illustrated in FIG. 1.
FIG. 3 is a perspective view of a second block, a third block, and a fourth block illustrated in FIG. 1.
FIG. 4 is a perspective view of a portion of the first block and a portion of the second block illustrated in FIG. 1.
FIG. 5A is a perspective view illustrating the third block, the fourth block, and a support plate illustrated in FIG. 3.
FIG. 5B is a perspective view of the third block and the fourth block illustrated in FIG. 5A vertically inverted.
FIGS. 6A to 6C are perspective views illustrating a reciprocating movement of a sub-body.
FIG. 7 is a perspective view of an electronic device according to an embodiment of the present disclosure.
FIG. 8 is an exploded perspective view according to an embodiment of the present disclosure.
FIG. 9 is a plan view of a display module according to an embodiment of the present disclosure.
FIGS. 10A and 10B are cross-sectional views of the display module according to an embodiment of the present disclosure.
FIGS. 11A to 11C are views illustrating a method of manufacturing the electronic device illustrated in FIG. 8.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the example embodiments of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or some specification, and should not be interpreted in an idealized or overly formal sense, unless expressly so defined herein.

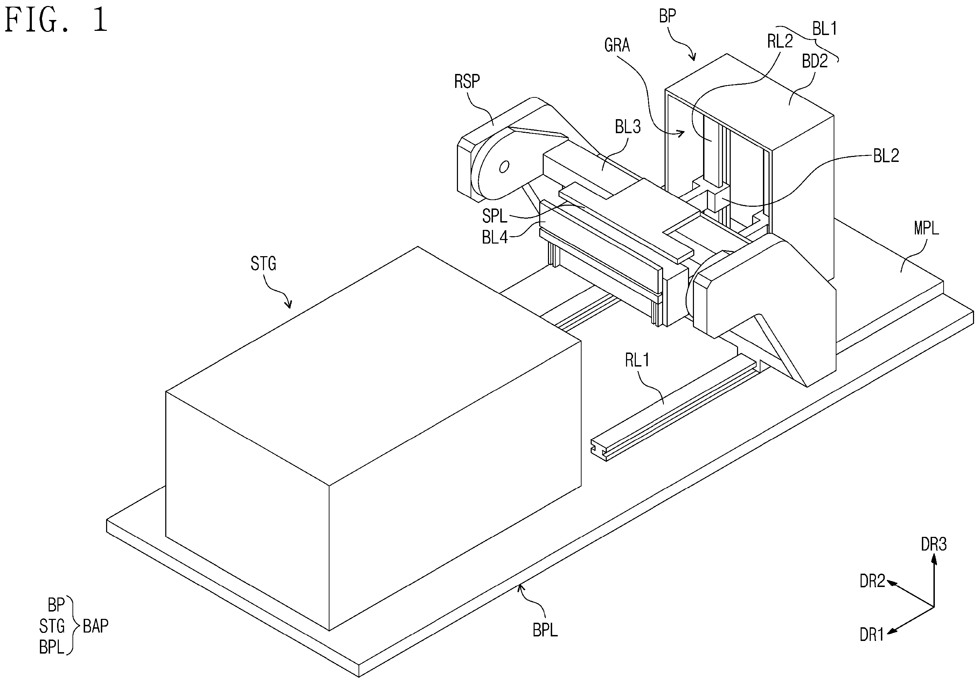

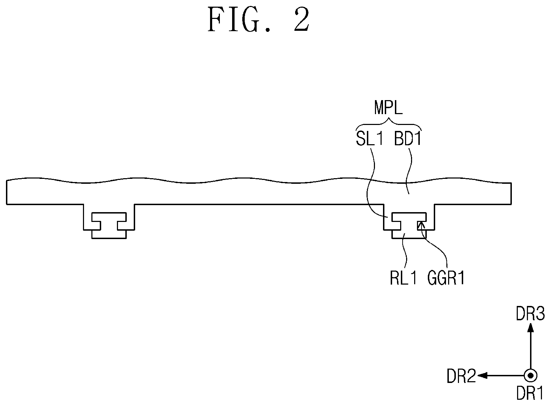

FIG. 1 is a perspective view of a bending device according to an embodiment of the present disclosure. FIG. 2 is a side view of a portion of a main plate and first rails illustrated in FIG. 1.

Referring to FIG. 1, a bending device BAP may include a base plate BPL, a stage STG, and a bending part BP. The base plate BPL may have a rectangular parallelepiped shape (e.g., a rectangular prism shape). An upper surface of the base plate BPL may be parallel to a plane defined by a first direction DR1 and a second direction DR2 crossing (e.g., intersecting) the first direction DR1. The upper surface of the base plate BPL may have a rectangular shape having long sides extending in the first direction DR1 and short sides extending in the second direction DR2. However, embodiments of the present disclosure are not limited thereto, and the base plate BPL may have various shapes.

Hereinafter, a direction substantially perpendicular to the plane defined by the first direction DR1 and the second direction DR2 is defined as a third direction DR3. Further, in the specification, the wording "when viewed on a plane" refers to a state of being viewed from the third direction DR3.

The stage STG may be disposed on the upper surface of the base plate BPL. The stage STG may have a rectangular parallelepiped shape. An upper surface of the stage STG may have a rectangular shape having long sides extending in the first direction DR1 and short sides extending in the second direction DR2. However, embodiments of the present disclosure are not limited thereto, and the stage STG may have various shapes.

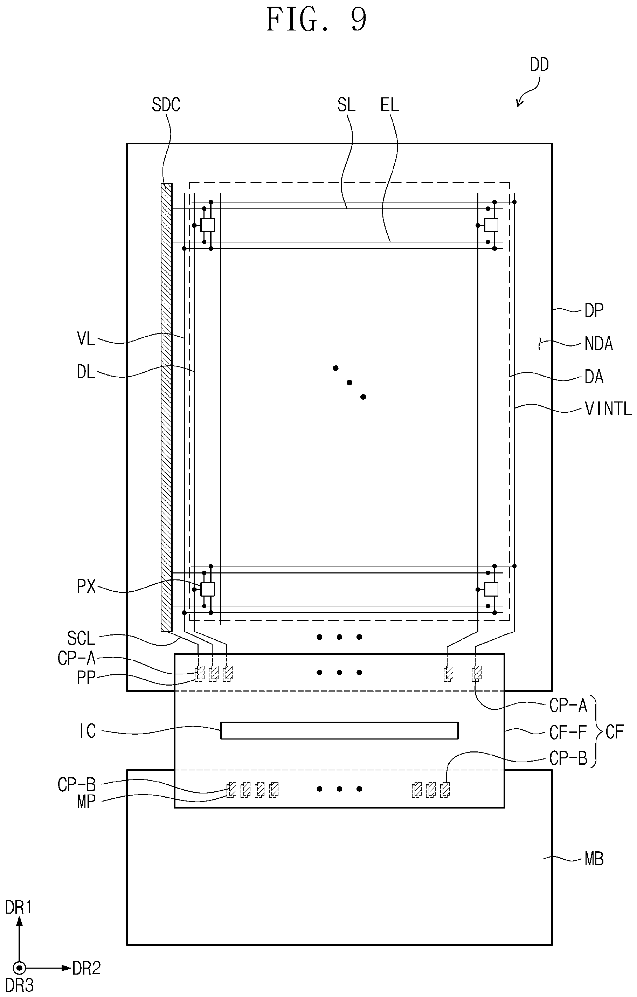

A plurality of adsorption holes (or adsorption openings) may be defined on an upper surface of the stage STG. When a display panel DP (see, e.g., FIG. 9), which will be described in more detail below, is disposed on the upper surface of the stage STG, the adsorption holes may be converted into a vacuum state (e.g., a vacuum may be applied to the adsorption holes) to fix the display panel DP (see, e.g., FIG. 9).

The bending part BP may be disposed on the upper surface of the base plate BPL. The bending part BP may be adjacent to the stage STG in the first direction DR1. The bending part BP and the stage STG may be arranged in (e.g., may be adjacent to each other in) the first direction DR1.

Referring to FIGS. 1 and 2, the bending part BP may include a plurality of first rails RL1, a main plate MPL, a first block BL1, a second block BL2, a plurality of rotation support portions RSP, a third block BL3, a support plate SPL, and a fourth block BL4. The first rails RL1 may extend in the first direction DR1 and may be spaced apart from each other in the second direction DR2.

First guide grooves GGR1 may be defined in (or defined on) side surfaces of the first rails RL1 opposite to each other in the second direction DR2. The first guide grooves GGR1 may extend in the first direction DR1. The first guide grooves GGR1 may have a shape corresponding to a portion of a quadrangle (e.g., may be a recess defining an opening for receiving a portion of a quadrangle).

The main plate MPL may be disposed on the first rails RL1. The main plate MPL may be coupled to the first rails RL1. The main plate MPL may reciprocate in the first direction DR1 along the first guide grooves GGR1.

The main plate MPL may include a support portion BD1 and a plurality of first sliding portions SL1. The support portion BD1 may have a rectangular parallelepiped shape. However, the shape of the support portion BD1 is not limited thereto.

The first sliding portions SL1 may be arranged on a lower surface of the support portion BD1. The first sliding portions SL1 may be arranged to be spaced apart from each other in the second direction DR2.

The first sliding portions SL1 may be coupled to the first rails RL1. The first sliding portions SL1 may be arranged inside the first guide grooves GGR1. The first sliding portions SL1 may slide along the first rails RL1 to reciprocate in the first direction DR1.

The first sliding portions SL1 may be linear motion guides. Balls (e.g., ball bearings) may be arranged between the first sliding portions SL1 and the first rails RL1. Accordingly, the first sliding portions SL1 may slide in the first direction DR1 along the first rails RL1.

When the first sliding portions SL1 reciprocate in the first direction DR1, the support portion BD1 disposed on the first sliding portions SL1 may reciprocate in the first direction DR1. Accordingly, an interval (e.g., a spacing) between the stage STG and the bending part BP may vary.

The first block BL1 may be disposed on an upper surface of the main plate MPL. The first block BL1 may be disposed adjacent to an edge of the main plate MPL. The first block BL1 may be disposed adjacent to one side facing the stage STG among sides of the main plate MPL opposite to each other in the first direction DR1. When the main plate MPL reciprocates in the first direction DR1, the first block BL1 may reciprocate in the first direction DR1.

The first block BL1 may include a block body BD2 and a plurality of second rails RL2. The block body BD2 may have a rectangular parallelepiped shape. An upper surface of the block body BD2 may be parallel to the plane defined by the first direction DR1 and the second direction DR2. The block body BD2 may have short sides extending in the first direction DR1 and long sides extending in the second direction DR2. However, the shape of the block body BD2 is not limited thereto.

A groove GRA may be defined in (or defined on) a side surface facing the stage STG from among both side surfaces of the block body BD2 opposite to each other in the first direction DR1. The groove GRA may extend from one side surface toward the other side surface of the block body BD2 in the first direction DR1.

The second rails RL2 may be arranged in the groove GRA. The second rails RL2 may extend in the third direction DR3 and may be spaced apart from each other in the second direction DR2.

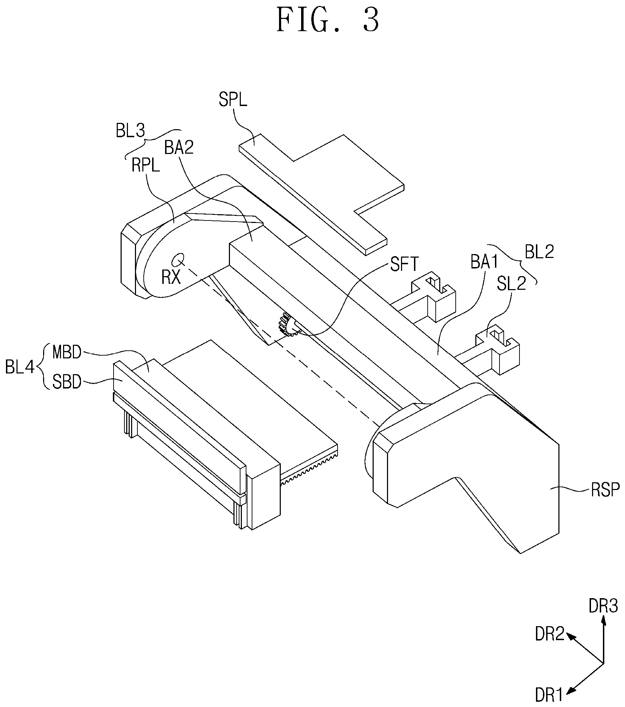

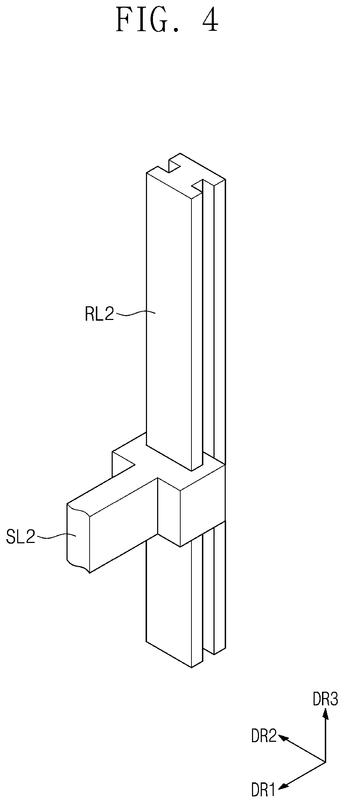

FIG. 3 is a perspective view of a second block, a third block, and a fourth block illustrated in FIG. 1. FIG. 4 is a perspective view of a portion of the first block and a portion of the second block illustrated in FIG. 1.

For convenience of description, FIG. 4 illustrates the one second rail RL2 from among the plurality of second rails RL2 and one second sliding portion SL2 from among a plurality of second sliding portions SL2.

Hereinafter, descriptions of the components in FIGS. 3 and 4 that are the same as or substantially similar to the components described above will be omitted or simplified.

Referring to FIGS. 1 and 3, the rotation support portions RSP may extend in the first direction DR1. The rotation support portions RSP may be spaced apart from each other in the second direction DR2. The rotation support portions RSP may be arranged on both sides of the first block BL1 opposite to each other in the second direction DR2. The first block BL1 may be disposed between the rotation support portions RSP spaced apart from each other in the second direction DR2.

The second block BL2 may be disposed between the rotation support portions RSP. The second block BL2 may be disposed on inner surfaces of the rotation support portions RSP facing each other in the second direction DR2.

A portion of the second block BL2 may be coupled to the second rails RL2 of the first block BL1. The second block BL2 may reciprocate along the second rails RL2 in the third direction DR3. Reciprocating movement of the second block BL2 in the third direction DR3 will be described in detail with reference to FIG. 4.

Further, when the first block BL1 and the main plate MPL reciprocate in the first direction DR1, the second block BL2 and the rotation support portions RSP may reciprocate in the first direction DR1.

The second block BL2 may include a first bar portion BA1 and the plurality of second sliding portions SL2. The first bar portion BA1 may extend in the second direction DR2. The first bar portion BA1 may be disposed on the inner surfaces of the rotation support portions RSP.

The second sliding portions SL2 may be arranged on one side surface opposite to the other side surface facing the third block BL3 from among both sides of the first bar portion BA1, which are opposite to each other in the first direction DR1. The second sliding portions SL2 may be arranged on one side surface of the first bar portion BA1 in the second direction DR2. The second sliding portions SL2 may extend from the first bar portion BA1 in the first direction DR1. The first bar portion BA1 and the second sliding portions SL2 may be integrally formed.

Referring to FIGS. 1 and 4, the second sliding portions SL2 may be coupled to the second rails RL2. The second sliding portions SL2 may reciprocate along the second rails RL2 in the third direction DR3. The second sliding portions SL2 may be linear motion guides. Balls (e.g., ball bearings) may be arranged between the second sliding portions SL2 and the second rails RL2.

When the second sliding portions SL2 reciprocate in the third direction DR3, the rotation support portions RSP connected to the second sliding portions SL2 may reciprocate in the third direction DR3.

Referring to FIGS. 1 and 3, the third block BL3 may be disposed between the rotation support portions RSP. The third block BL3 may be disposed on the inner surfaces of the rotation support portions RSP facing each other. The third block BL3 may be disposed above the second block BL2. The third block BL3 may be closer to the stage STG than the second block BL2 is.

Because the third block BL3 is connected to the rotation support portions RSP, when the rotation support portions RSP reciprocate in the third direction DR3, the third block BL3 may reciprocate in the third direction DR3. Further, when the rotation support portions RSP reciprocate in the first direction DR1, the third block BL3 may reciprocate in the first direction DR1.

The third block BL3 may include a second bar portion BA2 and a plurality of rotation plates RPL. The second bar portion BA2 may extend in the second direction DR2. The second bar portion BA2 may have a rectangular parallelepiped shape, but the shape of the second bar portion BA2 is not limited thereto.

The rotation plates RPL may be arranged on both side surfaces of the second bar portion BA2, which are opposite to each other in the second direction DR2. The rotation plates RPL may be spaced apart from each other in the second direction DR2. The second bar portion BA2 may be disposed between the rotation plates RPL.

From among both side surfaces of the rotation plates RPL, which are opposite to each other in the second direction DR2, one side surfaces facing each other may be coupled to the second bar portion BA2, and the other side surfaces may be arranged on the inner surfaces of the rotation support portions RSP.

The rotation plates RPL may rotate about a rotation axis RX parallel to the second direction DR2. The rotation axis RX may be adjacent to one of the sides of the rotation plates RPL opposite to each other in the first direction DR1. One of the sides of the rotation plates RPL opposite to each other in the first direction DR1 may be defined as a side that is spaced apart from the second bar portion BA2.

Because the rotation plates RPL rotate about the rotation axis RX, the second bar portion BA2 may rotate about the rotation axis RX.

The support plate SPL may be disposed on an upper surface of the third block BL3. The support plate SPL may be disposed on an upper surface of the second bar portion BA2. When the third block BL3 reciprocates in the first direction DR1 and the third direction DR3, the support plate SPL may reciprocate in the first direction DR1 and the third direction DR3. Further, when the second bar portion BA2 rotates about the rotation axis RX, the support plate SPL may rotate about the rotation axis RX.

A main circuit board MB (see, e.g., FIG. 9), which will be described below, may be disposed on an upper surface of the support plate SPL. A plurality of adsorption holes may be defined on the upper surface of the support plate SPL. When the main circuit board MB (see, e.g., FIG. 9) is disposed on the upper surface of the support plate SPL, the adsorption holes may be converted into a vacuum state (e.g., a low pressure state) to fix the main circuit board MB (see, e.g., FIG. 9).

The bending part BP (see, e.g., FIG. 1) may further include a shaft SFT. The shaft SFT may be disposed under the third block BL3. The shaft SFT will be described in detail below.

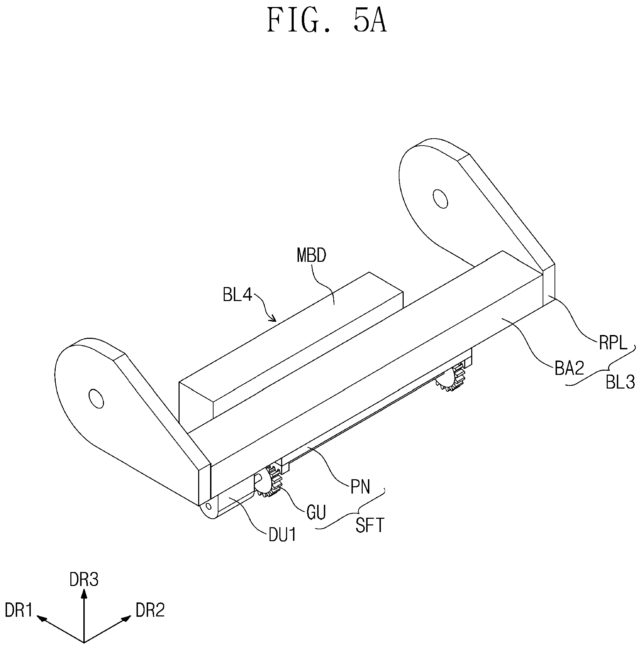

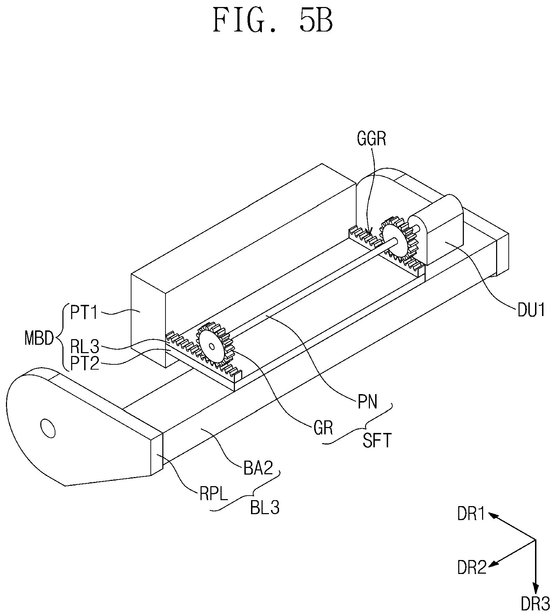

FIG. 5A is a perspective view illustrating a third block, a fourth block, a shaft, and a first driving unit illustrated in FIG. 3. FIG. 5B is a perspective view of the third block and the fourth block illustrated in FIG. 5A vertically inverted.

For convenience of description, the support plate SPL is omitted in FIGS. 5A and 5B.

Hereinafter, descriptions of the components that are the same or substantially similar to those described above will be omitted or simplified.

Referring to FIGS. 3 and 5A, the fourth block BL4 may be disposed adjacent to one side, which is spaced apart from the second block BL2, from among the sides of the second bar portion BA2, which are opposite to each other in the first direction DR1. The fourth block BL4 may be connected to the third block BL3. When the third block BL3 reciprocates in the first direction DR1 and the third direction DR3, the fourth block BL4 may reciprocate in the first direction DR1 and the third direction DR3. When the third block BL3 rotates about the rotation axis RX, the fourth block BL4 may rotate about the rotation axis RX.

The fourth block BL4 may include a main body MBD and a sub-body SBD. The main body MBD may be coupled to the third block BL3. When the third block BL3 reciprocates in the third direction DR3, the main body MBD may reciprocate in the third direction DR3.

Referring to FIGS. 3 and 5B, the main body MBD may include a first portion PT1, a second portion PT2, and third rails RL3. The first portion PT1 may be disposed adjacent to one side, which is spaced apart from the second block BL2, from among both sides of the second bar portion BA2, which are opposite to each other in the first direction DR1. The second portion PT2 may extend from the first portion PT1 in the first direction DR1. The second portion PT2 may extend from the first portion PT1 and may be disposed on a lower surface of the second bar portion BA2. For example, the first portion PT1 and the second portion PT2 may be integrally formed.

The third rails RL3 may be arranged on a lower surface of the second portion PT2. The third rails RL3 may be arranged adjacent to both sides of the second portion PT2, which are opposite to each other in the second direction DR2. The third rails RL3 may be spaced apart from each other in the second direction DR2.

The third rails RL3 may extend in the first direction DR1. A plurality of guide grooves GGR may be defined in (or defined on) lower surfaces of the third rails RL3. The guide grooves GGR may extend in the second direction DR2 and may be arranged in the first direction DR1. The lower surfaces of the third rails RL3 may be defined as surfaces opposite to an upper surface facing the lower surface of the second bar portion BA2.

The bending part BP (see, e.g., FIG. 1) may further include a first driving unit DU1 and the shaft SFT. The first driving unit DU1 may be disposed on the lower surface of the second bar portion BA2. The first driving unit DU1 may be a motor that operates (e.g., is configured to operate) when an electrical signal is received from the outside.

The shaft SFT may be connected to the first driving unit DU1. The shaft SFT may extend in the second direction DR2. When the first driving unit DU1 operates, the shaft SFT may rotate about a rotation axis parallel to the second direction DR2.

The shaft SFT may include a pin PN and a plurality of gears GR. The pin PN may extend in the second direction DR2. The pin PN may be connected to the first driving unit DU1. When the first driving unit DU1 operates, the pin PN may rotate about the rotation axis parallel to the second direction DR2.

The gears GR may be coupled to the pin PN. The gears GR may be arranged adjacent to both sides of the pin PN, which are opposite to each other in the second direction DR2. When the pin PN rotates about the rotation axis parallel to the second direction DR2, the gears GR may rotate about the rotation axis parallel to the second direction DR2.

The gears GR may be arranged on the lower surfaces of the third rails RL3. The gears GR may be engaged with the guide grooves GGR of the third rails RL3. When the gears GR rotate about the rotation axis parallel to the second direction DR2, the third rails RL3 may move in the first direction DR1. As the third rails RL3 move, the first portion PT1 and the second portion PT2 may move in the first direction DR1.

However, this is merely illustrative, and the third rails RL3 and the gears GR may be helical gears including a worm gear and a wheel gear.

The sub-body SBD shown in FIG. 3 may be coupled to the main body MBD. The sub-body SBD may be disposed on one side, which is spaced apart from the second block BL2, from among both sides of the main body MBD, which are opposite each other in the first direction DR1. When the main body MBD reciprocates in the first direction DR1, the sub-body SBD may reciprocate in the first direction DR1.

The sub-body SBD may reciprocate on one side of the main body MBD in the third direction DR3. Movement of the sub-body SBD in the third direction DR3 will be described in detail below.

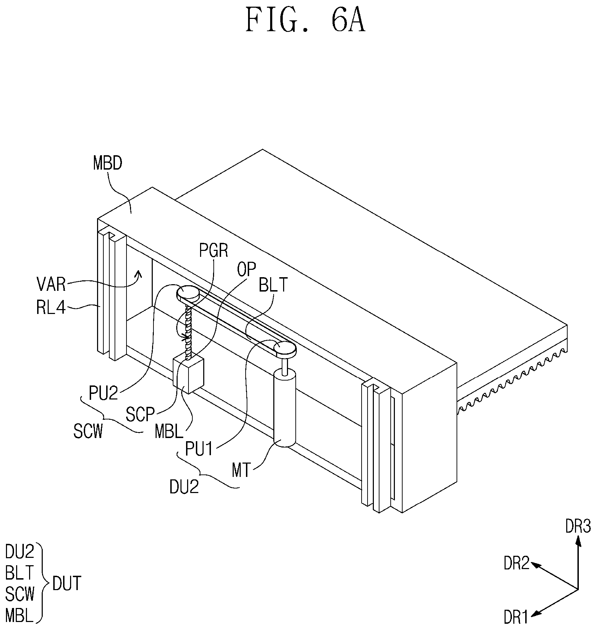

FIGS. 6A to 6C are perspective views illustrating reciprocating movement of a sub-body.

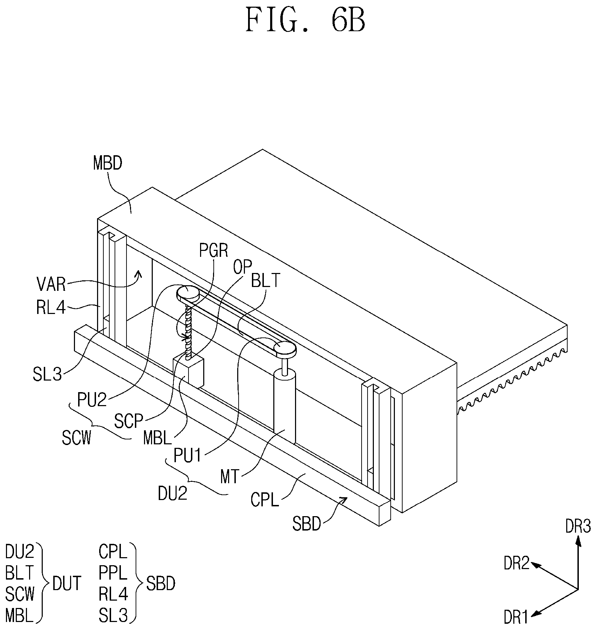

For convenience of description, a portion of the main body MBD is omitted in FIGS. 6A to 6C, a connection plate CPL and a molding plate PPL are omitted in FIG. 6A, and the molding plate PPL is omitted in FIG. 6B.

Hereinafter, descriptions of the components that are the same or substantially similar to those described above will be omitted or simplified.

Referring to FIG. 6A, the bending part BP (see, e.g., FIG. 1) may further include a driving unit DUT. The driving unit DUT may be disposed inside the main body MBD. The driving unit DUT may be disposed inside an accommodation portion VAR defined inside the main body MBD.

The driving unit DUT may include a second driving unit DU2, a screw SCW, a timing belt BLT, and a connection member MBL. The second driving unit DU2 may include a motor MT and a first pulley PU1. The motor MT may operate by receiving an electrical signal from the outside.

The first pulley PU1 may be connected to the motor MT. When the motor MT operates by (or in response to) receiving an electrical signal, the first pulley PU1 may rotate about a rotation axis parallel to the third direction DR3.

The screw SCW may be disposed adjacent to the second driving unit DU2 in the second direction DR2. For example, the screw SCW may extend in the third direction DR3.

The screw SCW may include a second pulley PU2 and a screw part SCP. The screw part SCP may extend in the third direction DR3. A rotation groove PGR extending in the third direction DR3 while surrounding (e.g., extending around a periphery of) the screw part SCP may be defined in (or defined on) an outer surface of the screw part SCP.

The second pulley PU2 may be disposed on the screw part SCP. The second pulley PU2 may be connected to the screw part SCP. For example, the second pulley PU2 and the screw part SCP may be integrally formed.

The timing belt BLT may connect the first pulley PU1 and the second pulley PU2. When the motor MT operates, and when the first pulley PU1 rotates about the rotation axis parallel to the third direction DR3, the second pulley PU2 connected by the timing belt BLT may rotate about the rotation axis parallel to the third direction DR3. When the second pulley PU2 rotates, the screw part SCP may rotate about the rotation axis parallel to the third direction DR3.

The connection member MBL may be coupled to the screw SCW. The screw part SCP may be coupled to the connection member MBL. The screw part SCP may be inserted into a through-hole (or opening) OP defined in the connection member MBL. Protrusions corresponding to the rotation groove PGR may be arranged on an inner surface of the connection member MBL defining the through-hole OP. The protrusions and the rotation groove PGR may be engaged with each other inside the through-hole OP. Accordingly, when the screw part SCP rotates about the rotation axis parallel to the third direction DR3, the connection member MBL may reciprocate in the third direction DR3. The connection member MBL may linearly move by the screw part SCP.

However, this is merely illustrative, and the connection member MBL may linearly move by using a linear motor.

Referring to FIGS. 6A to 6C, the sub-body SBD may be connected to the connection member MBL. When the connection member MBL reciprocates in the third direction DR3, the sub-body SBD may reciprocate in the third direction DR3.

The sub-body SBD may include the connection plate CPL, the molding plate PPL, a plurality of fourth rails RL4, and a plurality of third sliding portions SL3. The fourth rails RL4 may be arranged on one side of the main body MBD. The fourth rails RL4 may be arranged adjacent to both sides of the main body MBD, which are opposite to each other in the second direction DR2. The fourth rails RL4 may extend in the third direction DR3 and may be spaced apart from each other in the second direction DR2.

The connection plate CPL may have a bar shape extending in the second direction DR2. However, the shape of the connection plate CPL is not limited thereto.

The connection plate CPL may be coupled to the connection member MBL. When the connection member MBL reciprocates in the third direction DR3, the connection plate CPL may reciprocate in the third direction DR3.

The third sliding portions SL3 may be arranged on one side surface of the connection plate CPL, which faces the main body MBD. The third sliding portions SL3 may be arranged between the connection plate CPL and the fourth rails RL4. The third sliding portions SL3 may be coupled to the fourth rails RL4 and reciprocate in the third direction DR3. For example, the third sliding portions SL3 may be linear motion guides.

When the connection plate CPL reciprocates in the third direction DR3 by the connection member MBL, the third sliding portions SL3 connected to the connection plate CPL may reciprocate along the fourth rails RL4 in the third direction DR3.

The molding plate PPL may be parallel to a plane defined by the second direction DR2 and the third direction DR3. When viewed from the first direction DR1, the molding plate PPL may have a rectangular shape having long sides extending in the second direction DR2 and short sides extending in the third direction DR3.

The molding plate PPL may be disposed on the connection plate CPL. The molding plate PPL may be coupled to the third sliding portions SL3. The molding plate PPL may be connected to the connection plate CPL and the connection member MBL by the third sliding portions SL3. When the connection plate CPL reciprocates in the third direction DR3, the molding plate PPL may reciprocate in the third direction DR3.

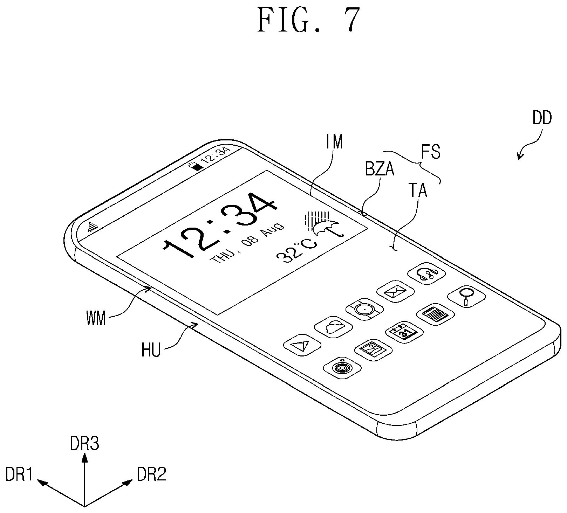

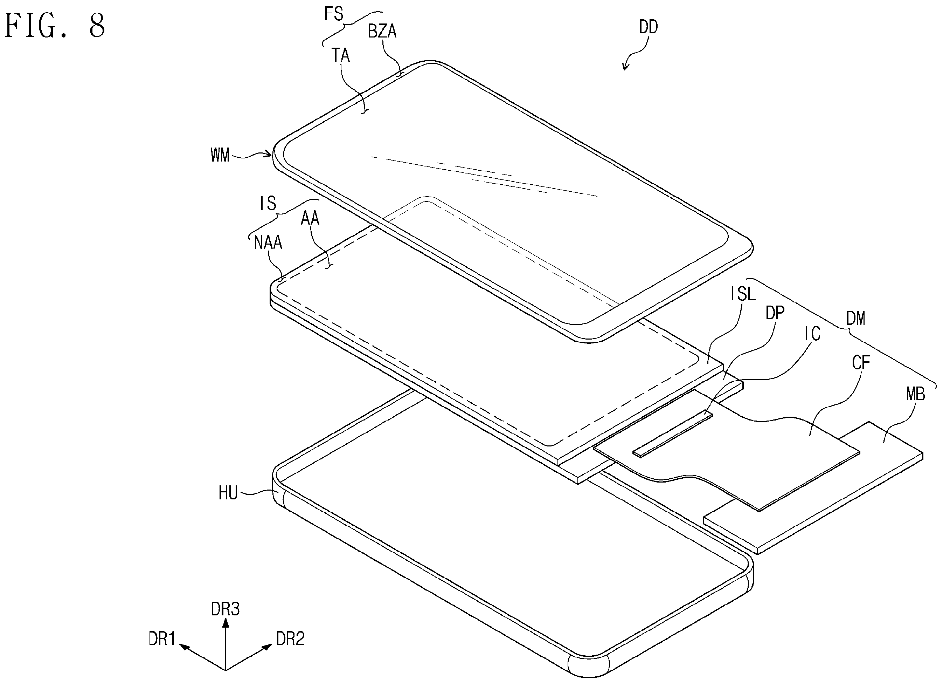

FIG. 7 is a perspective view of an electronic device according to an embodiment of the present disclosure. FIG. 8 is an exploded perspective view according to an embodiment of the present disclosure.

An electronic device DD may be a device that is activated according to an electric signal. The electronic device DD may include an embodiment. For example, the electronic device DD may be applied to electronic devices, such as mobile phones, smart watches, tablets, laptops, computers, smart televisions, and the like. The electronic device according to embodiments of the present disclosure is not limited to the above examples and may be (or may be adopted in) other electronic devices without departing from the concept of the present disclosure. In embodiments, the electronic device DD may be a mobile phone.

The electronic device DD may display an image IM in the third direction DR3 on a display surface FS parallel to the first direction DR1 and the second direction DR2. The display surface FS on which the image IM is displayed may correspond to a front surface of the electronic device DD. The image IM may include a still image as well as a dynamic image. FIG. 7 illustrates a clock and icons as an example of the image IM.

In embodiments, a front surface (e.g., an upper surface) and a rear surface (e.g., a lower surface) of each member may be defined with respect to a direction in which the image IM is displayed. The front surface and the rear surface may be opposite to each other in the third direction DR3, and a normal (e.g., perpendicular) direction of each of the front surface and the rear surface may be parallel to the third direction DR3. A separation distance between the front surface and the rear surface in the third direction DR3 may correspond to a thickness of the electronic device DD in the third direction DR3.

The electronic device DD may sense an external input applied from the outside. The external input may include various types of inputs provided from the outside of the electronic device DD. The external input, which is an input applied from the outside, may be provided in various forms.

For example, the external input may include a contact by a part of a body of the user, such as a hand, as well as an external input (e.g., hovering) applied (or moved) close to the electronic device DD or adjacent to the electronic device DD at or within a set distance (e.g., a preset or predetermined distance). Further, the external input may be one of various kinds, such as a force, a pressure, a temperature, a light, and the like.

The electronic device DD may include a window WM and a housing HU. The window WM and the housing HU may be coupled to each other to constitute an exterior of the electronic device DD.

The window WM may define a transmissive area TA and a bezel area BZA. The front surface of the electronic device DD may correspond to the transmissive area TA and the bezel area BZA of the window WM.

The transmissive area TA may be an area at where the image IM is displayed. The transmissive area TA may be an optically transparent area. The user may visually recognize the image IM through the transmissive area TA.

In embodiments, the transmissive area TA may have a quadrangular shape having rounded vertexes. However, this is merely an example, the transmissive area TA may have various shapes, and embodiments of the present disclosure are not limited thereto.

The bezel area BZA may be an area having a relatively low light transmittance as compared to the transmissive area TA. For example, the bezel area BZA may be provided as an area on which a material having a color (e.g., a preset or predetermined color) is printed.

The bezel area BZA may be an area adjacent to the transmissive area TA. The bezel area BZA may surround (e.g., may extend around a periphery of) the transmissive area TA. Accordingly, a shape of the transmissive area TA may be substantially defined by the bezel area BZA. However, this is merely an example, and the bezel area BZA may be disposed adjacent to only one side of the transmissive area TA or may be omitted.

Referring to FIG. 8, the electronic device DD may include the window WM, a display module DM, and the housing HU. The display module DM may include the display panel DP, an input sensing unit ISL, a connection circuit board CF, a driving chip IC, and the main circuit board MB.

The window WM may be disposed on the display module DM. An image provided on (e.g., displayed by) the display module DM may be provided to the user through the window WM. The window WM may protect the display module DM.

The window WM may include an optically transparent material. For example, the window WM may include glass, sapphire, plastic, or the like. The window WM may have a single-layer structure or a multi-layer structure. For example, the window WM may include a plurality of plastic films coupled to each other or a glass substrate and a plastic film coupled to each other.

The display module DM may have a front surface IS having an active area AA and a peripheral area NAA. The active area AA may be an area that is activated according to an electric signal. In embodiments, the active area AA may be an area on which the image IM is displayed, and may be an area in which the external input is sensed.

The transmissive area TA may overlap at least a portion of the active area AA. Accordingly, the user may visually recognize the image IM or provide the external input through the transmissive area TA. However, this is merely an example, an area in which the image IM is displayed and an area in which the external input is sensed may be separated from each other inside the active area AA, and embodiments of the present disclosure are not limited thereto.

The peripheral area NAA may be an area covered by the bezel area BZA. The peripheral area NAA may be adjacent to the active area AA. The peripheral area NAA may surround (e.g., may extend around a periphery of) the active area AA. A driving circuit or driving wiring line for driving the active area AA may be disposed in the peripheral area NAA.

The display panel DP according to embodiments of the present disclosure may be a liquid crystal display panel or a light emitting display panel, but embodiments of the present disclosure are not limited thereto. For example, the light emitting display panel may be an organic light emitting display panel or a quantum dot light emitting display panel. A light emitting layer of the organic light emitting display panel may include an organic light emitting material. A light emitting layer of the quantum dot light emitting display panel may include a quantum dot, a quantum rod, or the like.

The display panel DP may be flexible. The word "flexible" as used herein refers to having a bendable property and may include a completely folded structure to a structure that may be partially bent. For example, the display panel DP may be a curved display panel or a foldable display panel. In other embodiments, the display panel DP may be rigid.

The input sensing unit ISL may be disposed on the display panel DP. As illustrated in FIG. 8, the input sensing unit ISL may be directly disposed on the display panel DP. For example, the input sensing unit ISL may be formed on the display panel DP by a continuous process, and an adhesive film may not be disposed between the input sensing unit ISL and the display panel DP. However, embodiments of the present disclosure are not limited thereto, and an adhesive film may be disposed between the input sensing unit ISL and the display panel DP. The input sensing unit ISL may be manufactured through a separate process from the display panel DP and then fixed to an upper surface of the display panel DP by an adhesive film.

The input sensing unit ISL may sense an external input applied from the outside. As described above, the input sensing unit ISL may sense the external input provided to the window WM.

The connection circuit board CF may connect the display panel DP and the main circuit board MB. The connection circuit board CF may be electrically connected to the display panel DP on one side adjacent to the display panel DP. The connection circuit board CF may be electrically connected to the main circuit board MB on the other side adjacent to the main circuit board MB.

The one connection circuit board CF connecting the display panel DP and the main circuit board MB is illustrated in an embodiment, but embodiments of the present disclosure are not limited thereto, and the connection circuit board CF may be provided as a plurality of connection circuit boards CF, which may connect the display panel DP and the main circuit board MB.

The connection circuit board CF may be a flexible printed circuit board that is flexible.

The connection circuit board CF may provide, to the display panel DP, an electrical signal for driving the display panel DP. The electrical signal may be generated in the connection circuit board CF or may be generated in the main circuit board MB.

The driving chip IC may be mounted on the connection circuit board CF. The driving chip IC may be mounted on the flexible printed circuit board to constitute a chip on film (COF).

The driving chip IC may include driving elements for driving pixels of the display panel DP. The driving chip IC may include a driving circuit, and the driving circuit may include an integrated circuit. The driving circuit may include a driving controller, a data driver, a voltage generator, and the like.

The main circuit board MB may include a main controller. The main circuit board MB may include signal wiring lines for transmitting control signals and image signals received from the main controller to the connection circuit board CF and the display panel DP. The main circuit board MB may be a rigid printed circuit board or a flexible printed circuit board.

For example, an input circuit board electrically connected to the input sensing unit ISL may be further included. The input circuit board may connect the input sensing unit ISL and the main circuit board MB. In an embodiment, the input circuit board may be provided as a flexible circuit film to connect the input sensing unit ISL and the main circuit board MB. The input circuit board provides an electrical signal for driving the input sensing unit ISL to the input sensing unit ISL. The electrical signal may be generated in the input circuit board or may be generated in the main circuit board MB.

Each of the connection circuit board CF and the input circuit board may be connected to the one main circuit board MB. One of the connection circuit board CF and the input circuit board may not be connected to the main circuit board MB, and embodiments of the present disclosure are not limited thereto.

The housing HU may be coupled to the window WM to provide an inner space (e.g., a preset inner space or a predetermined inner space). The display module DM may be accommodated in the inner space. The housing HU may protect the display module DM accommodated in the inner space from an external impact and may prevent foreign substances or moisture from penetrating into the display module DM.

The electronic device DD according to an embodiment may further include an electronic module that includes various functional modules for operating the display module DM, a power supply module that supplies power for the overall operation of the electronic device DD, a bracket that is coupled to the display module DM and/or the housing HU to divide the inner space of the electronic device DD, and/or the like.

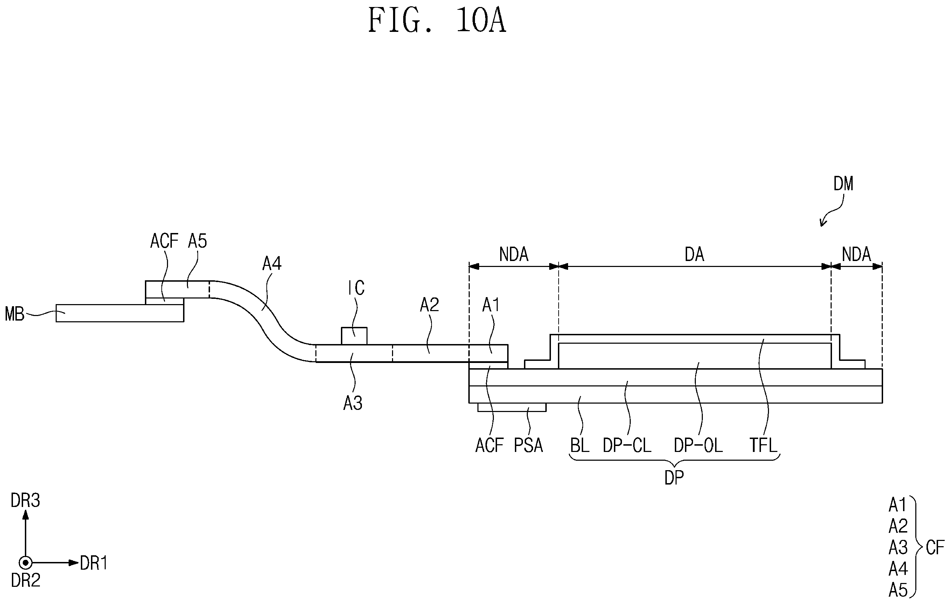

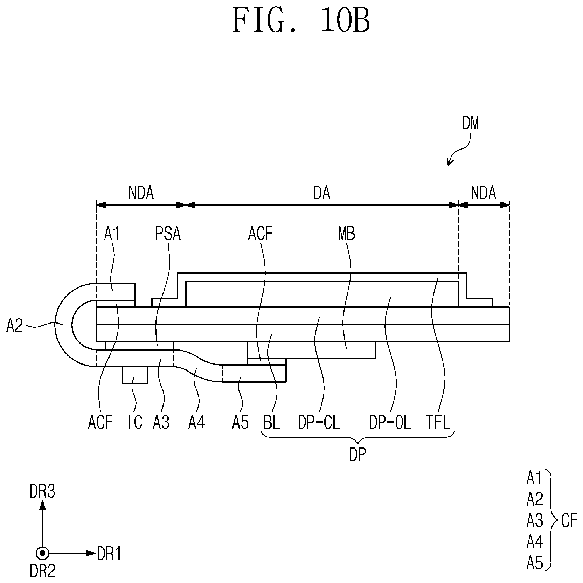

FIG. 9 is a plan view of a display module according to an embodiment of the present disclosure. FIGS. 10A and 10B are cross-sectional views of the display module according to an embodiment of the present disclosure.

Illustratively, FIG. 10B illustrates that the connection circuit board CF is bent.

Hereinafter, descriptions of the components that are the same or substantially similar to those described above will be omitted or simplified.

Referring to FIG. 9, in the display panel DP, a display area DA and a non-display area NDA may be defined on a plane. The display area DA may be an area at where an image is displayed. The non-display area NDA may be an area adjacent to the display area DA. The non-display area NDA may be an area at where an image is not displayed. The non-display area NDA may surround (e.g., may extend around a periphery of) the display area DA, but the shape thereof is not limited thereto.

The display panel DP may include a plurality of pixels PX, a scan driving circuit SDC, a plurality of signal lines, and a plurality of panel pads PP. The display panel DP may include scan lines SL, light emitting lines EL, data lines DL, a scan control line SCL, an initialization voltage line VINTL, and a voltage line VL as signal lines.

Each of the pixels PX may include a display element and a thin film transistor electrically connected to the display element. The display element may include, for example, an organic light emitting diode. The pixels PX may be arranged in the display area DA. However, embodiments of the present disclosure are not limited thereto, and some of the pixels PX may be arranged in the non-display area NDA.

The pixels PX may be arranged in a matrix form in the first direction DR1 and the second direction DR2 perpendicular to the first direction DR1. In embodiments of the present disclosure, the pixels PX may include a first pixel, a second pixel, and a third pixel for displaying a red light, a green light, and a blue light. In embodiments, the pixels PX may further include some of pixels for displaying a white light, a cyan light, and a magenta light.

The scan driving circuit SDC may be disposed adjacent to one side of the non-display area NDA. However, embodiments of the present disclosure are not limited thereto, and the scan driving circuit SDC may be disposed inside the display area DA. The scan driving circuit SDC may generate a plurality of scan signals and sequentially output the scan signals to the scan lines SL, which will be described below. The scan driving circuit SDC may further output another control signal to the driving circuits of the pixels PX.

The scan lines SL may extend from the scan driving circuit SDC in the second direction DR2 and may be connected to corresponding ones of the plurality of pixels PX. Each of the light emitting lines EL may extend from the scan driving circuit SDC in the second direction DR2 and may be arranged parallel to a corresponding one of the scan lines SL. The scan lines SL and the light emitting lines EL may be connected to the scan driving circuit SDC.

The data lines DL may extend in the first direction DR1 and may be connected to corresponding ones of the plurality of pixels PX. The scan control line SCL may provide control signals to the scan driving circuit SDC.

The initialization voltage line VINTL may provide an initialization voltage to the plurality of pixels PX. The voltage line VL may be connected to the plurality of pixels PX and may provide a voltage to the plurality of pixels PX. The voltage line VL may include a plurality of lines extending in the first direction DR1 and a plurality of lines extending in the second direction DR2.

Some of the scan lines SL, the data lines DL, the light emitting lines EL, the scan control line SCL, the initialization voltage line VINTL, and the voltage line VL may be arranged on the same layer, and the others may be arranged on different layers.

The panel pads PP may be arranged on the non-display area NDA. The panel pads PP may be arranged side by side in the second direction DR2. In the illustrated embodiment, the panel pads PP are arranged in a row in the second direction DR2, but embodiments of the present disclosure are not limited thereto. For example, the panel pads PP may be arranged in two or more rows or arranged in a zigzag form. The panel pads PP may be connected to the data lines DL, the scan control line SCL, the initialization voltage line VINTL, and the voltage line VL.

The connection circuit board CF may include a base layer CF-F, a plurality of panel connecting pads CP-A, and a plurality of board connecting pads CP-B.

The base layer CF-F may be an insulating layer on which the plurality of panel connecting pads CP-A and the plurality of board connecting pads CP-B are arranged. The base layer CF-F may include a flexible film.

The panel connecting pads CP-A may be arranged on one side adjacent to the display panel DP in the second direction DR2. Each of the panel connecting pads CP-A may be connected to a corresponding one of the panel pads PP of the display panel DP.

The panel pads PP may be arranged on the upper surface of the display panel DP, and the panel connecting pads CP-A may be arranged on a rear surface of the base layer CF-F. However, embodiments of the present disclosure are not limited thereto, and the panel pads PP may be arranged on a lower surface of the display panel DP, and the panel connecting pads CP-A may be arranged on an upper surface of the base layer CF-F.

The board connecting pads CP-B may be arranged on the other side adjacent to the main circuit board MB in the second direction DR2. The board connecting pads CP-B may be spaced apart from the panel connecting pads CP-A in the first direction DR1. The board connecting pads CP-B may be arranged on the rear surface of the base layer CF-F. However, embodiments of the present disclosure are not limited thereto, and the board connecting pads CP-B may be arranged on the upper surface of the base layer CF-F.

The connection circuit board CF may include a plurality of wiring lines. A plurality of wiring lines for electrically connecting the panel connecting pads CP-A and the driving chip IC and a plurality of wiring lines for electrically connecting the board connecting pads CP-B and the driving chip IC may be arranged on the base layer CF-F. The plurality of wiring lines may transmit electrical signals to components, each of which is connected to one end and the other end of the corresponding wiring line.

The main circuit board MB may include a plurality of board pads MP. The main circuit board MB may include a plurality of wiring lines connected to the board pads MP.

The board pads MP may be arranged on one side adjacent to the connection circuit board CF in the first direction DR1. The board pads MP may be arranged on an upper surface of the main circuit board MB. However, embodiments of the present disclosure are not limited thereto, and the board pads MP may be arranged on a rear surface of the main circuit board MB.

Each of the board pads MP may be connected to a corresponding one of the board connecting pads CP-B of the connection circuit board CF. The board connecting pads CP-B may be connected to the main controller through a wiring line and may receive the control signals and the image signals from the main controller. The board pads MP may transmit the received signals to the board connecting pads CP-B.

For example, in FIG. 9, to help understand the connection between the panel pads PP and the panel connecting pads CP-A and the connection between the board pads MP and the board connecting pads CP-B, the pads are illustrated in a misaligned state. However, the pads may be connected to the corresponding pads while overlapping with the corresponding pads.

Control signals and image signals transmitted from the driving circuit of the driving chip IC may be transmitted to the display panel DP without distortion only when the panel pads PP and the panel connecting pads CP-A are sufficiently connected. The control signals and the image signals received from the main controller of the main circuit board MB may be transmitted to the driving circuit of the driving chip IC without distortion when the board pads MP and the board connecting pads CP-B are sufficiently connected.

Referring to FIGS. 10A and 10B, the display panel DP may include a base substrate BL, a circuit element layer DP-CL, a display element layer DP-OL, and an encapsulation layer TFL. In embodiments, the display panel DP may also include an adhesive member PSA.

The base substrate BL may be a display substrate on which the circuit element layer DP-CL and the display element layer DP-OL are arranged. The base substrate BL may be a laminated structure including at least one silicon substrate, a plastic substrate, a glass substrate, an insulating film, or a plurality of insulating layers.

The circuit element layer DP-CL may be disposed on the base substrate BL. The circuit element layer DP-CL may include insulating layers, a plurality of conductive layers, and a semiconductor layer. The plurality of conductive layers may constitute the scan driving circuit SDC illustrated in FIG. 9, the signal lines, a control circuit of the pixel, and the like.

The display element layer DP-OL may be disposed on the circuit element layer DP-CL. The display element layer DP-OL may include the display elements included in the pixels PX illustrated in FIG. 9. For example, the display element layer DP-OL may include organic light emitting diodes. The display element layer DP-OL may further include an organic layer, such as a pixel defining film.

The encapsulation layer TFL may be disposed on the display element layer DP-OL. The encapsulation layer TFL may include a plurality of thin films. Some thin films may be arranged to improve optical efficiency, and some thin films may be arranged to protect a light emitting element.

The adhesive member PSA may be disposed on a lower surface of the base substrate BL. When viewed in the second direction DR2, the adhesive member PSA may be disposed on one side, which is adjacent to the connection circuit board CF, from among both sides of the base substrate BL, which are opposite to each other in the first direction DR1.

The connection circuit board CF according to an embodiment of the present disclosure may further include a conductive adhesive member ACF. The conductive adhesive member ACF may bond the panel pads PP of the display panel DP and the panel connecting pads CP-A of the connection circuit board CF. The conductive adhesive member ACF may bond the board pads MP of the main circuit board MB and the board connecting pads CP-B of the connection circuit board CF.

The conductive adhesive member ACF may be an anisotropic conductive film. The conductive adhesive member ACF may include a plurality of conductive balls that electrically connect the pads and an adhesive resin in which the conductive balls are dispersed.

For example, in other embodiments, the conductive adhesive member ACF may include an embodiment other than the anisotropic conductive film as long as the pads may be electrically connected to each other, and embodiments of the present disclosure re not limited thereto.

Referring to FIGS. 8 and 10A, heights of both sides of the connection circuit board CF, which are opposite to each other in the first direction DR1, may be different from each other. In a state in which the connection circuit board CF is not bent, a height of one side adjacent to the display panel DP from among both sides of the connection circuit board CF, which are opposite to each other in the first direction DR1, may be lower than a height of the other side thereof. An upper surface of the connection circuit board CF may include an inclination between both sides of the connection circuit board CF, which are opposite to each other in the first direction DR1.

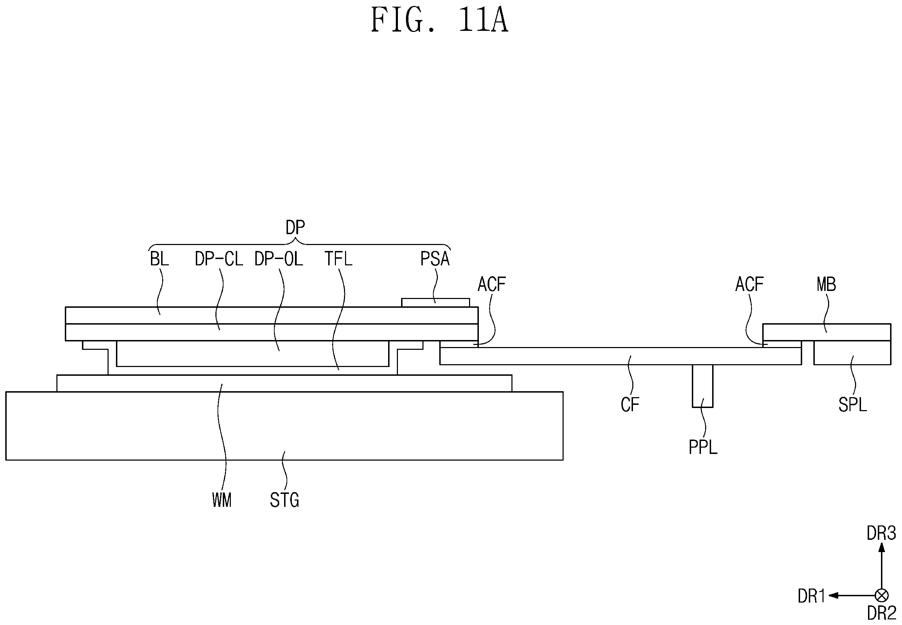

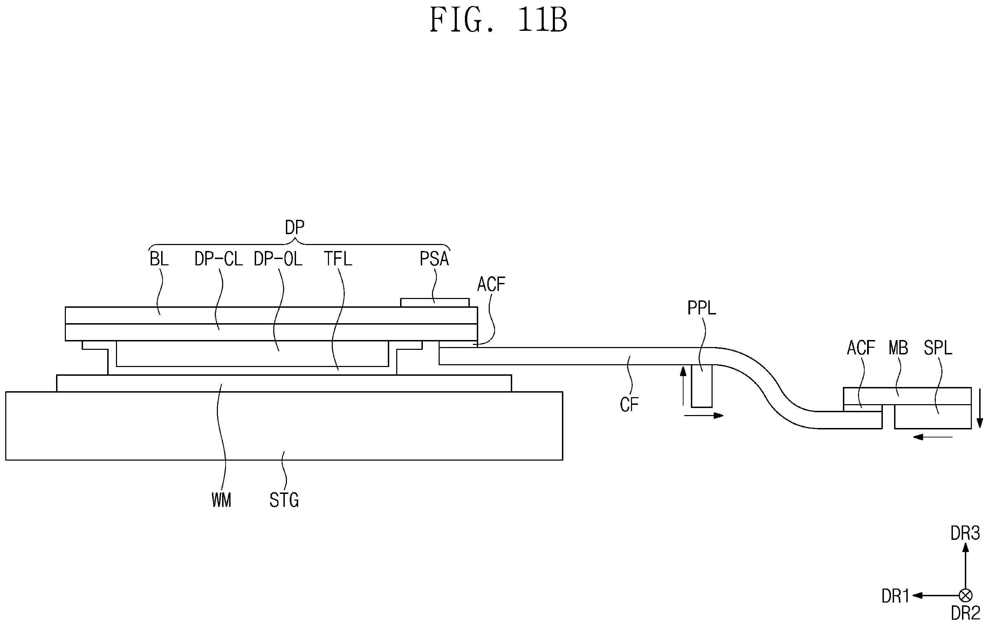

The connection circuit board CF may be molded by the bending part BP illustrated in FIG. 1. The molding of the connection circuit board CF will be described in detail with reference to FIGS. 11A to 11C.

Referring to FIGS. 10A and 10B, the connection circuit board CF may have a first area A1, a second area A2, a third area A3, a fourth area A4, and a fifth area A5. The first area A1 may be defined as a part of the connection circuit board CF, which overlaps the display panel DP.

The second area A2 may extend from the first area A1. As illustrated in FIG. 10B, the second area A2 may be defined as a part of the connection circuit board CF, which is bent about an axis parallel to the second direction DR2. The second area A2 may be bent, and thus, the third area A3, the fourth area A4, and the fifth area A5, and the main circuit board MB may be arranged under the display panel DP.

The third area A3 may extend from the second area A2. The third area A3 may be disposed under the display panel DP. The third area A3 may be attached to the lower surface of the base substrate BL by the adhesive member PSA.

The fourth area A4 may extend from the third area A3. The fourth area A4 may be defined as a part of the connection circuit board CF having an inclined surface on a lower surface thereof. A height of a lower surface of the fourth area A4 may be lowered toward the main circuit board MB. A height of an upper surface of the fourth area A4 may be lowered toward the main circuit board MB. The lower surface of the fourth area A4 may be defined as a surface opposite to the upper surface of the fourth area A4 facing the lower surface of the base substrate BL.

The fifth area A5 may extend from the fourth area A4. The fifth area A5 may be defined as a part of the connection circuit board CF, which overlaps the main circuit board MB. The fifth area A5 may be attached to the upper surface of the main circuit board MB.

When the connection circuit board CF is not molded, and when the second area A2 is bent, the third area A3 may be spaced apart from the lower surface of the base substrate BL. Accordingly, a space occupied by the third area A3 may be increased. Thus, a space for arranging the power supply module and/or the bracket required for the operation of the electronic device DD (see, e.g., FIG. 8) in the housing HU (see, e.g., FIG. 8) may be reduced.

Further, when the connection circuit board CF is bent and is then attached to the lower surface of the base substrate BL by pressing the third area A3, cracks may occur in the third area A3. Accordingly, a defect may occur in the electronic device DD (see, e.g., FIG. 8).

However, the connection circuit board CF according to embodiments of the present disclosure may be molded before being bent. The third area A3 may be attached to the lower surface of the base substrate BL. Accordingly, the space occupied by the third area A3 may be reduced. Thus, the power supply module and/or the bracket required for the operation of the electronic device DD (see, e.g., FIG. 8) may be easily arranged.

In addition, cracks occurring by pressing the third area A3 may be prevented. Thus, occurrence of defects of the electronic device may be prevented.

FIGS. 11A to 11C are views illustrating a method of manufacturing the electronic device illustrated in FIG. 8.

Illustratively, FIGS. 11A to 11C are cross-sectional views when viewed in the second direction DR2.

For convenience of description, FIGS. 11A to 11C illustrate only the molding plate PPL and the support plate SPL of the bending part BP.

Hereinafter, descriptions of the that are the same or substantially similar to those described above will be omitted or simplified.

Referring to FIG. 11A, a method of manufacturing the electronic device DD (see, e.g., FIG. 8) may include arranging the display panel DP on the stage STG and arranging the main circuit board MB on the support plate SPL. The connection circuit board CF may be disposed on the molding plate PPL.

Referring to FIGS. 1, 5B, 6C, and 11B, the method of manufacturing the electronic device DD (see, e.g., FIG. 8) may include molding the connection circuit board CF.

For example, when the main plate MPL moves in the first direction DR1, the support plate SPL connected to the main plate MPL may move in the first direction DR1. When the second block BL2 and the rotation support portions RSP move in a direction opposite to the third direction DR3 (e.g., in a downward direction), the support plate SPL connected to the second block BL2 and the rotation support portions RSP may move in the downward direction.

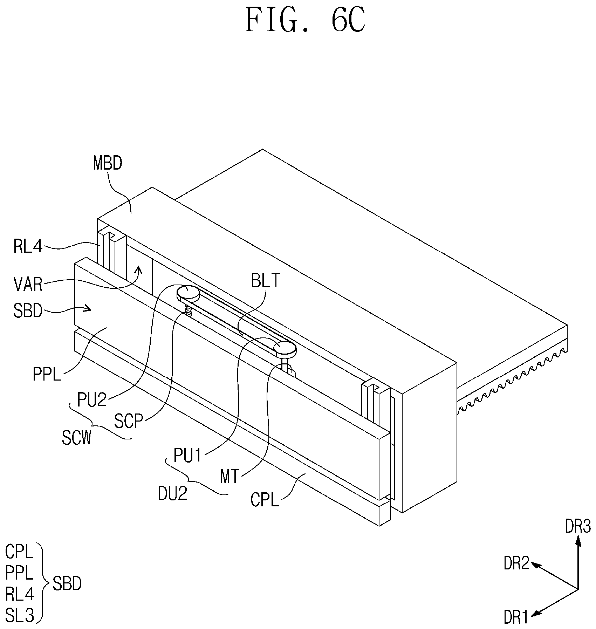

When the support plate SPL moves in the first direction DR1 and the downward direction, the molding plate PPL may move in a direction opposite to the first direction DR1 by the first driving unit DU1, the shaft SFT, and the main body MBD. The molding plate PPL may move in the third direction DR3 (e.g., in an upward direction) by the driving unit DUT of FIG. 6C.

For example, the movement direction of the support plate SPL and the movement direction of the molding plate PPL may be opposite to each other. Accordingly, even when the support plate SPL moves, a distance between the molding plate PPL and the stage STG on which the display panel DP is disposed may be constant.

As the support plate SPL moves, the height of the other side of the connection circuit board CF disposed on the support plate SPL may be lower than the height of the one side thereof. In this case, the molding plate PPL may support the connection circuit board CF so that the connection circuit board CF has an inclination. The connection circuit board CF may be formed to have an inclination between the support plate SPL and the molding plate PPL.

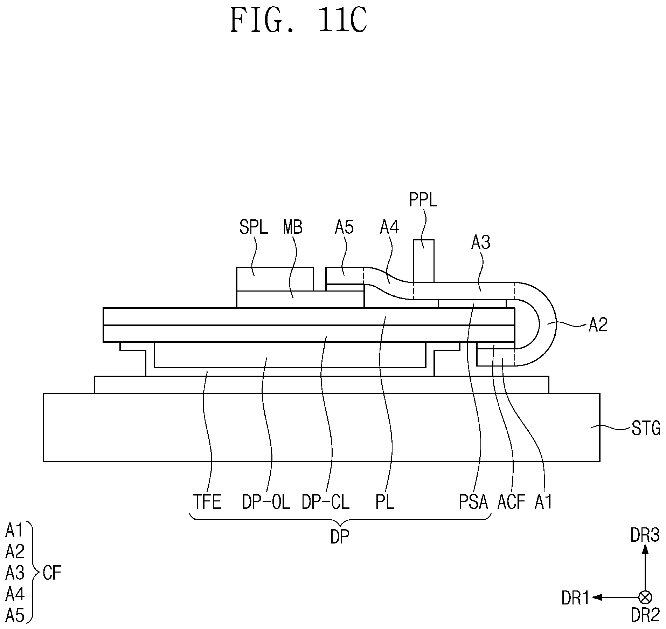

Referring to FIGS. 3 and 11C, the method of manufacturing the electronic device DD (see, e.g., FIG. 8) may include bending the connection circuit board CF. The third block BL3, the fourth block BL4 coupled to the third block BL3, and the support plate SPL disposed on the third block BL3 may rotate about the rotation axis RX shown in FIG. 3. The third block BL3, the fourth block BL4, and the support plate SPL may rotate on a plane defined by the first direction DR1 and the third direction DR3.

As the support plate SPL and the molding plate PPL rotate, the connection circuit board CF disposed on the support plate SPL and the molding plate PPL may be bent. The second area A2 of the connection circuit board CF may be bent. The third area A3 may be attached to the lower surface of the base substrate BL by the adhesive member PSA. The main circuit board MB may face the lower surface of the base substrate BL.

Because the connection circuit board CF is molded before the connection circuit board CF is bent, the space occupied by the third area A3 may be reduced. Thus, the power supply module and/or the bracket required for the operation of the electronic device DD (see, e.g., FIG. 8) may be easily arranged.

As discussed, embodiments can provide a bending device comprising: a stage configured to accommodate a display panel; and a bending part adjacent to the stage in a first direction and configured to accommodate a main circuit board, the bending part comprising: a main plate configured to reciprocate in the first direction; a first block on the main plate; a plurality of rotation supports arranged on sides of the first block, the sides of the first block being opposite to each other in a second direction intersecting the first direction; a second block between the rotation supports, coupled to the first block, and configured to reciprocate in a third direction intersecting a plane defined by the first direction and the second direction; a third block closer to the stage than the second block is, between the rotation supports, and configured to rotate about a rotation axis parallel to the second direction; and a fourth block coupled to one side of the third block facing the stage from among sides of the third block, the sides of the fourth block being opposite to each other in the first direction, and comprising a main body configured to reciprocate in the first direction and a sub-body coupled to the main body and configured to reciprocate in the third direction with respect to the main body.

Embodiments can provide a method of manufacturing an electronic device, the method comprising: arranging a display panel on a stage and arranging a connection circuit board electrically connected to the display panel and a main circuit board electrically connected to the connection circuit board on a bending part adjacent to the stage in a first direction; molding the connection circuit board as the bending part moves; and bending the connection circuit board as the bending part rotates about a rotation axis parallel to a second direction intersecting the first direction, wherein the bending part comprises: a main plate configured to reciprocate in the first direction; a first block on the main plate; a plurality of rotation supports arranged on sides of the first block, the sides being opposite to each other in the second direction intersecting the first direction; a second block between the rotation supports, coupled to the first block, and configured to reciprocate in a third direction intersecting a plane defined by the first direction and the second direction; a third block that is closer to the stage than the second block between the rotation supports and rotates about a rotation axis parallel to the second direction; and a fourth block on one side facing the stage among sides of the third block, the sides being opposite to each other in the first direction.

Embodiments can provide an electronic device comprising: a display panel; a main circuit board on a rear surface of the display panel; a connection circuit board electrically connected to the display panel on one side thereof and electrically connected to the main circuit board on another side thereof, the connection circuit board having: a first area on the display panel; a second area extending from the first area and being bent; a third area under the display panel and extending from the second area; a fourth area extending from the third area and having an inclination; and a fifth area extending from the fourth area and attached to an upper surface of the main circuit board opposite to a lower surface of the main circuit board facing the display panel; and a driving chip mounted on the connection circuit board.

According to embodiments of the present disclosure, a bending device may mold a connection circuit board before bending the connection circuit board. Accordingly, when the connection circuit board is bent, a space occupied by the connection circuit board may be reduced.

Although embodiments of the present disclosure have been described above, those skilled in the art may understand that the present disclosure may be variously modified and changed without departing from the scope of the present disclosure as set forth in the appended claims and their equivalents. Further, it should be interpreted that the embodiments disclosed in the present disclosure are not intended to limit the present disclosure and all equivalents thereto are included in the scope of the present disclosure.

## Claims

1. A bending device comprising:
a stage configured to accommodate a display panel; and
a bending part adjacent to the stage in a first direction and configured to accommodate a main circuit board, the bending part comprising:
a main plate configured to reciprocate in the first direction;
a first block on the main plate;
a plurality of rotation supports arranged on sides of the first block, the sides of the first block being opposite to each other in a second direction intersecting the first direction;
a second block between the rotation supports, coupled to the first block, and configured to reciprocate in a third direction intersecting a plane defined by the first direction and the second direction;
a third block closer to the stage than the second block is, between the rotation supports, and configured to rotate about a rotation axis parallel to the second direction; and
a fourth block coupled to one side of the third block facing the stage from among sides of the third block, the sides of the fourth block being opposite to each other in the first direction, and comprising a main body configured to reciprocate in the first direction and a sub-body coupled to the main body and configured to reciprocate in the third direction with respect to the main body.

2. The bending device of claim 1, wherein the bending part comprises a first rail under the main plate and extending in the first direction, and
wherein the main plate is configured to reciprocate along the first rail in the first direction.

3. The bending device of claim 2, wherein the first block comprises:
a block body; and
a second rail in grooves defined in one side of the block body facing the stage from among the sides of the block body, which are opposite to each other in the first direction, and extend in the third direction, and
wherein the second block is configured to reciprocate along the second rail in the third direction.

4. The bending device of claim 3, wherein, in response to the second block reciprocating in the third direction, the rotation supports, the third block, and the main body are configured to reciprocate in the third direction.

5. The bending device of claim 3 or 4, wherein the bending part further comprises:
a first driving unit on a lower surface of the third block; and
a shaft extending in the second direction, connected to the first driving unit, and configured to rotate about a rotation axis parallel to the second direction,
wherein the main body comprises:
a first portion on the one side of the third block;
a second portion extending from the first portion in the first direction and on the lower surface of the third block; and
a third rail on a lower surface of the second portion, extending in the first direction, and engaged with the shaft, and
wherein, in response to the shaft rotating, the main body is configured to reciprocate in the first direction;
optionally wherein, in response to the main body moving in the first direction, the sub-body is configured to move in the first direction.

6. The bending device of claim 5, wherein the bending part further comprises:
a second driving unit inside the main body and rotating about a rotation axis parallel to the third direction;
a screw adjacent to the second driving unit and rotating about the rotation axis parallel to the third direction;
a timing belt configured to connect the second driving unit and the screw; and
a connection member coupled to the screw and configured to reciprocate along the screw in the third direction, and
wherein the sub-body is coupled to the connection member, and in response to the screw rotating, the sub-body is configured to reciprocate in the third direction;
optionally wherein a distance between the sub-body and the stage is constant.

7. The bending device of any one of claims 1 to 6, wherein the third block and the sub-body move in opposite directions.

8. A method of manufacturing an electronic device, the method comprising:
arranging a display panel on a stage and arranging a connection circuit board electrically connected to the display panel and a main circuit board electrically connected to the connection circuit board on a bending part adjacent to the stage in a first direction;
molding the connection circuit board as the bending part moves; and
bending the connection circuit board as the bending part rotates about a rotation axis parallel to a second direction intersecting the first direction,
wherein the bending part comprises:
a main plate configured to reciprocate in the first direction;
a first block on the main plate;
a plurality of rotation supports arranged on sides of the first block, the sides being opposite to each other in the second direction intersecting the first direction;
a second block between the rotation supports, coupled to the first block, and configured to reciprocate in a third direction intersecting a plane defined by the first direction and the second direction;
a third block that is closer to the stage than the second block between the rotation supports and rotates about a rotation axis parallel to the second direction; and
a fourth block on one side facing the stage among sides of the third block, the sides being opposite to each other in the first direction.

9. The method of claim 8, wherein the bending part further comprises a first rail under the main plate and extending in the first direction, and
wherein the main plate is configured to reciprocate along the first rail in the first direction.

10. The method of claim 9, wherein the first block comprises:
a block body; and
a second rail in grooves defined on one side of the block body facing the stage from among sides of the block body, the grooves extending in a third direction intersecting a plane defined by the first direction and the second direction, the sides of the block body being opposite to each other in the first direction, and
wherein the second block is configured to reciprocate along the second rail in the third direction, and
wherein, in response to the second block reciprocating in the third direction, the rotation supports, the third block, and the fourth block are configured to reciprocate in the third direction.

11. The method of claim 10, wherein the bending part further comprises:
a first driving unit on a lower surface of the third block; and
a shaft extending in the second direction, connected to the first driving unit, and configured to rotate about a rotation axis parallel to the second direction, and
wherein the fourth block comprises:
a main body coupled to one side of the third block facing the stage from among sides of the third block opposite to each other in the first direction and configured to reciprocate in the first direction; and
a sub-body connected to the main body and configured to reciprocate in the third direction with respect to the main body.

12. The method of claim 10, wherein the main body comprises: a first portion on the one side of the third block; a second portion extending from the first portion in the first direction and on the lower surface of the third block; and a third rail on a lower surface of the second portion, extending in the first direction, and engaged with the shaft, and wherein, in response to the shaft rotating, the main body is configured to move in a direction opposite to the first direction; and /or
wherein the bending part further comprises: a second driving unit inside the main body and configured to rotate about a rotation axis parallel to the third direction; a screw adjacent to the second driving unit and configured to rotate about the rotation axis parallel to the third direction; a timing belt configured to connect the second driving unit and the screw; and a connection member coupled to the screw, and wherein the sub-body is coupled to the connection member, and in response to the screw rotating, the sub-body is configured to reciprocate in the third direction.

13. The method of any one of claims 8 to 11, wherein heights of sides of the connection circuit board opposite to each other in the first direction are different from each other;
optionally wherein the molded connection circuit board has an inclination.

14. An electronic device comprising:
a display panel;
a main circuit board on a rear surface of the display panel;
a connection circuit board electrically connected to the display panel on one side thereof and electrically connected to the main circuit board on another side thereof, the connection circuit board having:
a first area on the display panel;
a second area extending from the first area and being bent;
a third area under the display panel and extending from the second area;
a fourth area extending from the third area and having an inclination; and
a fifth area extending from the fourth area and attached to an upper surface of the main circuit board opposite to a lower surface of the main circuit board facing the display panel; and
a driving chip mounted on the connection circuit board.

15. The electronic device of claim 14, wherein the third area of the connection circuit board is attached to the rear surface of the display panel; and/or
wherein a height of an upper surface of the fourth area of the connection circuit board facing the rear surface of the display panel decreases toward the main circuit board.
